**Europäisches Patentamt**

**European Patent Office**

**Office européen des brevets**

(11) Numéro de publication: **0 053 069**
**B1**

(12) **FASCICULE DE BREVET EUROPEEN**

(45) Date de publication du fascicule du brevet:
**14.11.84**

(21) Numéro de dépôt: **81401820.6**

(22) Date de dépôt: **19.11.81**

(51) Int. Cl.³: **H 02 H 3/50**, G 01 R 31/08

(54) Procédé pour déterminer la direction de l'origine d'une perturbation affectant un élément d'un réseau de transport d'énergie électrique.

(30) Priorité: **25.11.80 FR 8024946**

(43) Date de publication de la demande:
**02.06.82 Bulletin 82/22**

(45) Mention de la délivrance du brevet:
**14.11.84 Bulletin 84/46**

(84) Etats contractants désignés:
**CH DE GB LI SE**

(56) Documents cités:
**FR - A - 2 313 683**
**FR - A - 2 316 772**
**FR - A - 2 422 278**

**IEE PROCEEDINGS-C, vol. 127, juillet 1980, Stevenage, GB A.T. JOHNS: "New ultra-high-speed directional comparison technique for the protection of e.h.v. transmission lines", pages 228-239**

㜀 Titulaire: **ENERTEC, 12 Place des Etats Unis, F-92120 Montrouge (FR)**

㜂 Inventeur: **Heller, Isabelle, 17 rue Léon Cladel, F-92310 Sèvres (FR)**
Inventeur: **Loewenstein, Paul, 4001 Miranda Avenue, Palo Alto California 94304 (US)**

㜄 Mandataire: **Bentz, Jean-Paul, GIERS SCHLUMBERGER Service BREVETS 12, place des Etats-Unis, F-92124 Montrouge Cedex (FR)**

## Description

La présente invention concerne un procédé pour déterminer, en un point de mesure d'un réseau de transport d'énergie électrique, situé à une extrémité d'une section protégée d'un élément de ce réseau, tel qu'une ligne de transport d'électricité, la direction qui, àpartir de ce point, indique l'origine d'une perturbation affectant cet élément, ce procédé comprenant les étapes consistant à mettre en évidence, à partir de signaux de mesure de tension et de courant audit point de mesure, une grandeur ayant le signe algébrique de l'intégrale de la différence entre une onde de puissance transitoire aller passant par le point de mesure et progressant de l'extérieur de la section protégée vers cette section, et une onde de puissance transitoire retour passant par le point de mesure et progressant de la section protégée vers l'extérieur de cette section, ladite intégrale représentant l'énergie transitoire totale passant par le point de mesure, et à déduire ladite direction de la nature du signe algébrique de ladite grandeur déterminée.

On sait que les réseaux de transport d'énergie électrique sont le siège de perturbations électriques diverses, telles que branchements ou débranchements de générateurs ou de charges, les plus graves de ces perturbations, dénommées défauts, consistant par exemple en des court-circuits d'un ou plusieurs des câbles d'une ligne à la terre, ou, dans le cas d'un réseau à courant polyphasé, entre les câbles d'une même ligne qui sont affectés à des phases différentes.

Pour prévenir les effets destructeurs des défauts, les réseaux de transport d'énergie électrique sont dotés de détecteurs et de dispositifs complexes de contrôle et de commande propres à assurer, dans les délais les plus brefs après l'apparition du défaut, la protection de l'élément de réseau en défaut, par exemple de la ligne ou du transformateur par la mise hors circuit de cet élément.

Compte tenu de ce que chaque détecteur effectue des mesures instantanées de courant et de tension en un point donné de l'élément de réseau, il est nécessaire, en ce point de mesure, non seulement de pouvoir mettre en évidence l'existence d'un défaut sur l'élément de réseau mais également de pouvoir déterminer de quel côté de ce point se trouve le défaut.

On sait depuis longtems que l'apparition d'un défaut sur un élément de réseau engendre une énergie transitoire par phase dont la polarité indique le sens de déplacement, donc la direction de l'origine du défaut par rapport au point de mesure.

Traditionnellement, on utilise deux détecteurs, connus sous le nom de relais directionnels, chaque relais étant disposé à l'extrémité d'une section à protéger d'un élément d'un réseau de transport d'énergie électrique. Cette section est généralement choisie de façon à ne comporter aucun équipement susceptible d'engendrer des pertubations en service normal, et chaque relais a pour fonction de détecter si une pertubation provient de la section protégée ou non. Pour ce faire chaque relais surveille, pendant un certain temps au moins après le début de toute perturbation détectée, le signe de l'énergie transitoire totale passant au point de mesure, par exemple mis en évidence par la similitude ou la disparité des signes de la tension et de l'intensité de l'onde transitoire. Pour chaque pertubation, les directions détectées par les relais sont comparées, par exemple par communication radio. Si les deux relais indiquent que la pertubation provient de la section protégée, des mesures sont immédiatement prises pour protéger l'élément de réseau concerné; dans le cas contraire, la pertubation est considérée comme étant externe à la section protégée.

Une difficulté survient dans le cas où l'impédance en amont de relais est faible, par exemple, pour une ligne de transport d'électricité, dans le cas où la seule impédance significative à l'extérieur de la section protégée est celle d'un puissant générateur d'énergie électrique connecté à la ligne à proximité du relais.

En effet si l'on considère, en théorie, l'énergie transitoire totale passant au point de mesure comme l'intégrale en fonction du temps de la différence entre une onde de puissance transitoire aller progressant de l'extérieur de la section protégé, ou amont, vers cette section, et une onde de puissance transitoire retour, progressant de la section protégée vers l'extérieur, il apparait que la détection de la direction du défaut est d'autant plus délicate que les ondes aller et retour sont semblables en amplitude et voisines dans le temps, la raison en étant que le signe d'une grandeur physique positive ou négative et très proche de zéro est empreint d'une grande incertitude. Or, dans le cas d'un défaut affectant la section protégée et de l'existence d'une faible impédance en amont du relais directionnel, l'onde aller est constituée par la réflexion de l'onde retour en amont du relais, et ces deux ondes ont des amplitudes très voisines, en raison de l'absence quasi totale d'atténuation, et sont très proches dans le temps.

Il en résulte, dans la détermination de la direction de l'origine du défaut par rapport au point de mesure, un risque d'erreur que la présente invention a précisément pour but de supprimer.

Le procédé de l'invention, qui comprend de façon connue les opérations consistant à mettre enévidence une grandeur dont le signe algébrique est celui de l'énergie transitoire totale passant au point de mesure et à déduire, de la nature du signe algébrique de cette grandeur, la direction de l'origine de la pertubation, est essentiellement caractérisé en ce que ladite grandeur a un module sensiblement égal, à une constante multiplicative près, à l'intégrale de la différence instantanée entre l'onde de puissance transitoire aller, retardée d'un intervalle de temps au plus égal au double du temps de propagation d'une onde de puissance transitoire sur la section protégée, et l'onde de puissance transitoire retour.

Il est bien entendu, dès à présent et pour la suite de la description, que les expressions telles que «onde de puissance», «différence d'ondes de puissance» et «intégrale de la différence des ondes de puissance» peuvent évidemment désigner les grandeurs physiques ainsi dénommées mais également, par souci de concision, les signaux représentatifs de ces grandeurs physiques.

Dans le cas où l'élément de réseau est une ligne présentant une capacité totale négligeable, l'onde de puissance transitoire aller retardée peut être obtenue à tout instant, en simulant, à partir de l'onde de puissance transitoire aller passant par le point de mesure à cet instant et des caractéristiques de la ligne, la fraction de l'onde de puissance transitoire aller qui, ayant traversé le point de mesure, passera ou au moins devrait passer, à un instant postérieur, en un point de la section protégée, distant du point de mesure, par exemple au milieu de la section protégée.

D'autres caractéristiques et avantages de l'invention ressortiront clairement de la description qui en est faite ci-après, à titre indicatif et nullement limitatif, en référence au dessin annexé sur lequel.

La figure 1 est un schéma représentant un câble d'une ligne de transport d'énergie électrique, avec une section protégée par deux relais directionnels, un élément de faible impédance extérieur à la section protégée et un défaut également extérieur à la section protégée.

La figure 2 est un schéma représentant un câble d'une ligne de transport d'énergie électrique avec une section protégée par deux relais directionnels, un élément de faible impédance extérieur à la section protégée, et un défaut dans cette section.

Les figures 3 et 4 sont des diagrammes respectivement correspondants aux figures 1 et 2 et représentant chacun, en ordonnée positive, dans un référentiel d'énergie E en fonction du temps $t$, l'intégrale de l'onde de puissance transitoire progressant de l'extérieur de la section protégée vers cette section (onde aller), et, en ordonnée négative, l'intégrale de l'onde de puissance transitoire progressant en sens inverse (onde retour).

La figure 5 est un schéma d'un dispositif pour la mise en oeuvre du procédé de l'invention.

La figure 6 est un schéma d'un autre dispositif pour la mise en oeuvre du procédé de l'invention, applicable au cas d'une ligne présentant une capacité totale négligeable.

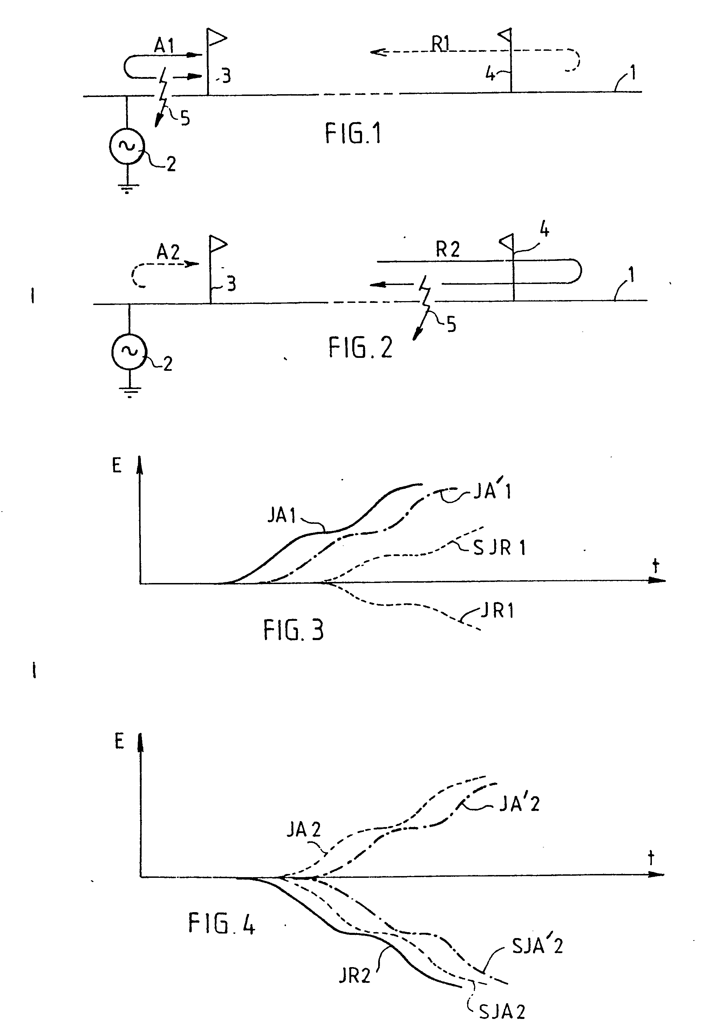

Sur les figures 1 et 2 sont représentés un câble 1 d'une ligne de transport d'énergie électrique, un générateur 2 d'énergie électrique connecté à la ligne, et deux relais directionnels 3 et 4 protégeant la section de ligne qui se trouve comprise entre eux, le générateur 2 présentant une impédance faible et constituant l'élément impédant essentiel en amont du relais 3.

Le câble 1 est affecté au transport d'une phase dans le cas d'un courant polyphasé, et le générateur 2 est à l'extérieur de la section protégée, à proximité du relais directionnel 3.

Si un défaut 5 survient sur la ligne entre le générateur 2 et le relais 3, il apparait une onde de puissance transitoire A1, dite «aller» pour la raison qu'elle se dirige vers la section protégée (flèches en traits pleins sur la figure 1), dont l'intégrale en fonction du temps adopte par exemple la forma JA1 représentée sur la figure 3, également en trait plein. Cette conde «aller» est réfléchie au-delà de l'autre relais directionnel, 4, et forme une onde retour R1 à laquelle correspond l'intégrale JR1 (en pointillés sur les figures 1 et 3).

Au niveau du relais 3, l'onde retour présente par rapport à l'onde aller d'une part une amplitude sensiblement atténuée en raison de la perte d'énergie qui s'est produite à la réflexion et au cours de la propagation de l'onde sur le double au moins de la longueur de la section protégée, et d'autre part un décalage sensible dans le temps, correspondant au temps de propagation sur le double au moins de la longueur de la section protégée.

Cette atténuation et ce décalage temporel, qui se retrouvent sur les intégrales JA1 et JR1 de ces ondes de puissance, sont mis clairement en évidence sur la figure 3, sur laquelle les intégrales des ondes de puissance sont représentées avec des formes arbitraires et sur laquelle les énergies JA1 et JR1 sont représentées en ordonnées respectivement positive et négative.

Si SJR1 désigne la courbe symétrique de JR1 par rapport à l'axe des abscisses $t$, l'énergie transitoire totale qui s'est déjà manifestée, pour une phase, au temps $t$, est représentée par la différence, de signe positif, entre l'ordonnée de JA1 et celle de SJR1 pour ce même temps $t$. La figure 3 monte clairement que cette différence a un module relativement important, de sorte que le signe de cette différence peut être identifié de façon aisée.

Par contre si l'on considère maintenant les figures 2 et 4, illustrant le cas où un défaut 5 survient sur la section protégée, on remarque que la situation est sensiblement différente.

Le relais directionnel 3 reçoit d'abord l'onde retour R2, à laquelle correspond l'intégrale JR2, (en traits pleins sur les figures 2 et 4), et cette onde se réfléchit sur l'élément de faible impédance 2 pour constituer l'onde aller A2, à laquelle correspond l'intégrale JA2 (en pointillés sur les figures 2 et 4). Mais, compte tenu de ce que la réflexion est alors quasi totale et de ce que le trajet du relais 3 au générateur 2 est court, l'onde aller passe par le relais 3 très peu de temps après l'onde retour et avec sensiblement la même amplitude.

Cet effet, qui se retrouve sur les intégrales JA2 et JR2 des ondes de puissance aller et retour, est mis en évidence sur la figure 4.

Les courbes représentées sur cette figure ont des formes arbitraires et les énergies JA2 et JR2 sont représentées en ordonnées respectivement positive et négative.

Si SJA2 désigne la courbe symétrique de JA2 par rapport à l'axe des abscisses $t$, l'énergie transitoire qui s'est déjà manifestée, pour une phase, au temps $t$, est représentée par la différence, de signe négatif, entre l'ordonnée de JR2 et celle de SJA2 pour ce même temps $t$. La figure 4 montre clairement que cette différence a un module faible, de sorte que la détermination du signe algébrique de cette différence est entachée d'un risque d'erreur important.

Le procédé de l'invention consiste essentiellement à retarder le signal représentatif de l'onde de puissance aller A2 (en pointillés sur la figure 2) d'un intervalle de temps au plus égal au double du temps de propagation d'une onde de puissance transitoire sur la longueur de la section protégée, de préférence, cet intervalle de temps est choisi égal à ce temps de propagation lui-même.

A l'onde de puissance, dont ce signal retardé est représentatif, correspond une intégrale temporelle ou énergie JA'2, redardée par rapport à JA2. Si SJA'2 désigne la courbe symétrique de JA'2 par rapport à l'axe des temps, la grandeur dont le signe algébrique est pris en considération pour la détermination de la direction de l'origine du défaut est, suivant l'invention, la différence entre les ordonnées correspondantes des courbes JR2 et SJA'2 ou toute grandeur proportionnelle à cette différence. Comme on le constate en observant la figure 4 cette différence a un module supérieur à celui de la différence entre les ordonnées de JR2 et SJA2, de sorte que son signe peut être identifié avec une plus grande sécurité.

Il convient évidemment de faire remarquer que le retard virtuellement introduit dans l'onde aller est aussi responsable, (figure 3) du déplacement de la courbe JA1 à la courbe JA'1 dans le cas d'un défaut à l'extérieur de la section protégée. Ce déplacement ne modifie cependant pas, tant qu'il reste inférieur au temps de propagation d'une onde de puissance transitoire sur le double de la longueur de la section protégée, le signe algébrique de la différence entre l'onde aller retardée et l'onde retour. En effet, tant que JA'1 n'est pas (figure 3) déplacée à droite de SJR1, la grandeur dont on observe le signe, à savoir la différence entre les ordonnées correspondantes de JA'1 et de SJR1, garde le même signe. De préférence toutefois, pour que le module de cette différence soit suffisamment grand pour que la détermination de son signe soit sûre, le retard introduit est égal ou voisin du temps de propagation d'une onde de puissance sur la longueur de la section protégée, JA'1 étant alors sensiblement à mi-distance entre JA1 et SJR1.

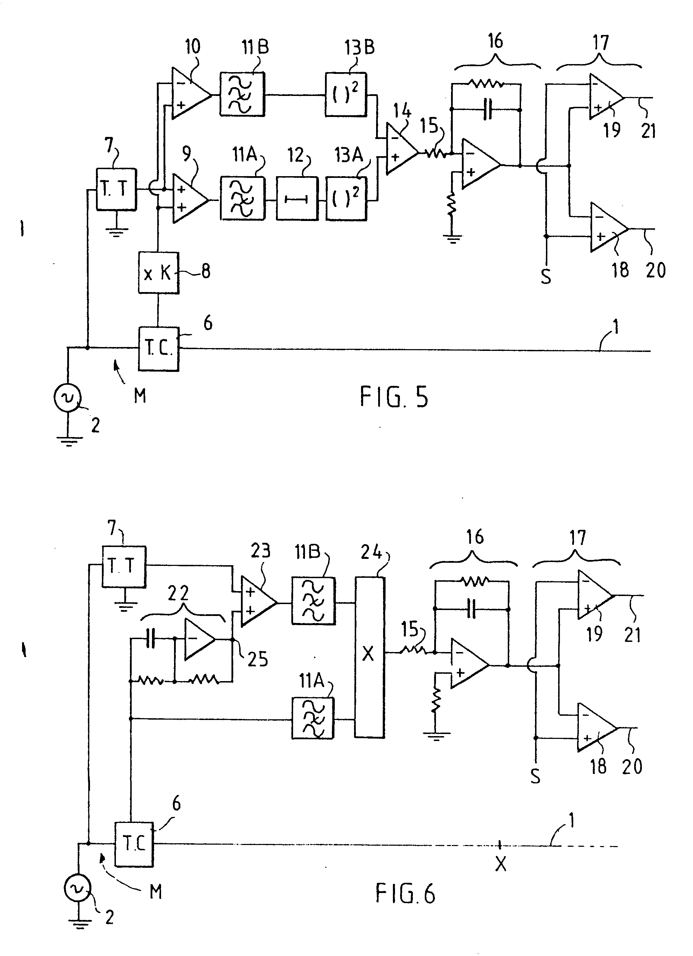

La figure 5 représente un dispositif propre, dans le cas général, à mettre en oeuvre le procédé de l'invention.

Ce dispositif fait intervenir, de façon classique, un transformateur de courant 6 en série sur le câble 1 de la ligne et un transformateur de tension 7 en dérivation, et comprend un multiplicateur 8 pour multiplier le signal de sortie I du transformateur de courant 6 par un paramètre K prédéterminé, un additionneur 9 et un soustracteur 10 pour former respectivement les signaux $V + KI$ et $V - KI$, V étant le signal de sortie du transformateur de tension 7, des filtres 11A et 11B pour éliminer des signaux $V + KI$ et $V - KI$ la fréquence de service normal du réseau de transmission ou de distribution d'énergie, une cellule à retard 12 pour retarder le signal $V + KI$ par exemple après filtrage, des générateurs de fonction 13A et 13B pour former les signaux $(V+KI)^2r$ et $(V-KI)^2$ respectivement, l'indice $r$ indiquant l'introduction du retard, un soustracteur 14 pour former le signal $\{(V+KI)^2r - (V-KI)^2\}$, un intégrateur 16 avec résistance d'entrée 15 pour former le signal $J = \int \{(V+KI)^2r - (V-KI)^2\}.dt$, et une logique d'état 17, comprenant deux comparateurs 18 et 19, recevant le signal J sur leur entrée respectivement négative et positive, et un signal de seuil S sur leur entrée respectivement positive et négative.

Le signal S est prévu compenser la valeur résiduelle du signal J en l'absence de défaut sur le câble 1. En effet, il a été plusieurs fois mentionné précédemment que la polarité de l'énergie transitoire totale se propageant sur le câble 1 affecté au transport d'une phase dans un réseau polyphasé, était, en cas de défaut sur cette phase, représentative de la direction de l'origine du défaut. Toutefois une énergie transitoire apparaît également, en cas de défaut, sur les phases qui ne sont pas en défaut, mais la polarité de cette énergie ne fournit aucune indication sur la direction de l'origine du défaut. Il est donc nécessaire d'identifier la ou les phases en défaut pour s'assurer de la validité de l'information relative à la direction de l'origine du défaut. Compte de ce que l'énergie transitoire totale apparaissant sur une phase en défaut est plus importante que celle qui apparaît sur une phase non affectée par le défaut, l'utilisation d'un signal de seuil S permet de n'obtenir l'activation positive de l'une des sorties 20 et 21 des comparateurs 18 et 19 que si le défaut affecte la phase surveillée par les transformateurs 6 et 7. A chaque sortie 20 ou 21 activée positivement correspond une direction de l'origine du défaut par rapport au point de mesure M où sont implantés les transformateurs 6 et 7.

Le paramètre K est fixé à une valeur égale à celle de l'impédance caractéristique de la ligne, de sorte que les signaux $V + KI$ et $V - KI$ représentent des tensions dont les carrés sont proportionnels aux puissances correspondant aux ondes aller et retour, respectivement.

L'homme de l'art comprendra, à la lecture de la description qui précède, que les filtres 11A, 11B et la cellule de retard 12 peuvent être disposés ailleurs dans le circuit décrit, le filtre 11A et la cellule 12 pouvant par exemple être intervertis.

La figure 6 représente un dispositif propre à mettre en oeuvre le procédé de l'invention dans le cas particulier d'une ligne courte, c'est-à-dire présentant une capacité totale faible, donc négligeable, c'est-à-dire encore, de façon plus précise, une ligne dont la fréquence quart d'onde est largement supérieure à la largeur de bande du signal utilisé pour la détermination de la direction de l'origine du défaut.

Ce dispositif comprend outre les éléments 11A, 11B, et 15 à 21 décrits en référence à la figure 5, un filtre dérivateur 22, un additionneur 23 et un multiplicateur 24.

Le filtre dérivateur 22 reçoit le signal I du transformateur de courant 6 et produit sur la sortie 25 le signal $-(RI + L\frac{dI}{dt})$ où R et L sont respectivement les images de la résistance et de l'inductance série d'une longueur donnée de la ligne, de préférence de la demi-longueur de la section protégée de cette ligne. L'additionneur 23 est relié par ses entrées au filtre 22 et au transformateur de tension 7, de sorte qu'il délivre à sa sortie un signal $U = V - RI - L\frac{dI}{st}$.

Ce signal U, homogène à une tension, représente celle qui sera ultérieurement, ou au moins serait pour une ligne sans défaut mais sur laquelle se propagent les mêmes ondes de puissance transitoire, la tension qui est associée à l'onde dont la fraction aller a traversé le point de mesure M et qui apparaît en un point X de la ligne, distant du point M et de préférence choisi au milieu de la section protégée.

Les filtres 11A et 11B éliminent, respectivement dans les signaux I et U, la fréquence de service normal du réseau, et les signaux I et U filtrés sont multipliés par le multiplicateur 24 dont la sortie attaque le montage 15 à 21 précédemment décrit. La capacité répartie de la ligne étant négligeable, l'intensité de

7       **0 053 069**       8

l'onde transitoire qui aurait pu être mesurée au point X de la section protégée est assimilable au signal I, de sorte que l'intégrateur 16 délivre un signal représentatif de l'intégrale de la différence entre une onde de puissance transitoire aller et une onde de puissance transitoire retour apparaissant en même temps en des points différents de la ligne ou, ce qui est équivalent, en un même point de la ligne mais à des instants différents, l'onde aller étant retardée par rapport à l'onde retour.

Par souci de clarté, la description qui précède se réfère à la détection de pertubations affectant des lignes de transport d'énergie électrique. Toutefois les mêmes techniques sont applicables à la protection d'autres éléments des réseaux d'énergie électrique, par exemple de transformateurs.

En outre, bien que les exemples fournis fassent usage de techniques analogiques, les techniques numériques peuvent également être appliquées. C'est ainsi par exemple, si l'on réfère à la figure 5, que des convertisseurs analogique-numérique pourraient être connectés à la sortie des transformateurs 6 et 7, et que les fonctions des éléments 8 à 19 pourraient être simulées par un ou plusieurs calculateurs.

**Revendications**

1. Procédé pour déterminer, en un point de mesure (M) d'un réseau de transport d'énergie électrique, situé à une extrémité d'une section protégée (3, 4) d'un élément de ce réseau, tel qu'une ligne de transport d'électricité (1), la direction qui, à partir de ce point, indique l'origine d'une pertubation affectant cet élément, ce procédé comprenant les étapes consistant à mettre en évidence, à partir de signaux de mesure de tension et de courant audit point de mesure, une grandeur ayant le signe algébrique de l'intégrale de la différence entre une onde de puissance transitoire aller (A1, A2) passant par le point de mesure et progressant de l'extérieur de la section protégée vers cette section, et une onde de puissance transitoire retour (R1, R2), passant par le point de mesure et progressant de la section protégée vers l'extérieur de cette section, ladite intégrale représentant l'énergie transitoire totale passant par le point de mesure, et à déduire ladite direction de la nature du signe algébrique de ladite grandeur déterminée, caractérisé en ce que, pour augmenter la sécurité de la détermination de ladite direction dans le cas d'une pertubation affectant la section protégée, ladite grandeur a un module sensiblement égal, à une constante multiplicative près, à l'intégrale de la différence instantanée entre ladite onde de puissance transitoire aller (A1, A2), retardée d'un intervalle de temps au plus égal au double du temps de propagation d'une onde de puissance transitoire sur la section protégée, et ladite onde de puissance transitoire retour (R1, R2).

2. Procédé suivant la revendication 1, caractérisé en ce que ledit intervalle de temps de retard est voisin du temps de propagation d'une onde de puissance transitoire sur la section protégée.

3. Procédé suivant la revendication 1, caractérisé en ce que ladite onde de puissance transitoire aller retardée est obtenue à tout instant en simulant à partir de l'onde de puissance transitoire passant par le point de mesure (M) à cet instant et des caractéristiques (R, L) dudit élément de réseau, la fraction aller de l'onde de puissance transitoire qui, ayant traversé le point de mesure, passera à un instant postérieur, ou au moins passerait pour un élément de réseau sans défaut sur lequel se propagent les mêmes ondes de puissance transitoire, en un point (X) de la section protégée, distant du point de mesure.

4. Procédé suivant la revendication 3, caractérisé en ce que ledit point (X) distant du point de mesure est sensiblement le milieu de la section protégée (3, 4).

5. Procédé suivant la revendication 3 ou 4, caractérisé en ce que ledit élément de réseau est une ligne courte (1) présentant une capacité totale négligeable.

**Patentansprüche**

1. Verfahren zur an einem Messpunkt (M) eines elektrischen Energietransportnetzes, der an einem Ende eines geschützten Abschnittes (3, 4) eines Elementes dieses Netzte wie eine Stromtransportleitung (1) liegt, erfolgenden Bestimmung der Richtung, die von diesem Punkte ausgehend den Ursprung einer Störung angibt, die auf dieses Element einwirkt, wobei das Verfahren die Schritte umfasst, die darin bestehen, aus Spannungs- und Strom-Messsignalen an dem genannten Messpunkt eine Grösse darzustellen, welches dasselbe algebraische Vorzeichen aufweist wie das Integral der Differenz zwischen einer hinlaufenden vorübergehenden Leistungsschwingung (A1, A2), die durch den Messpunkt geht und von ausserhalb des geschützten Abschnittes zu diesem Abschnitt hin fortschreitet, und einer rücklaufenden vorübergehenden Leistungsschwingung (R1, R2), die durch den Messpunkt geht und von dem geschützten Abschnitt nach ausserhalb dieses Abschnittes wandert, wobei dieses Integral die vorübergehende Gesamtenergie darstellt, die durch den Messpunkt geht, und die genannte Richtung aus der Art des algebraischen Vorzeichens der genannten bestimmten Grösse abzuleiten, dadurch gekennzeichnet, dass zur Steigerung der Sicherheit bei der Bestimmung der genannten Richtung im Falle einer Störung, welche den geschützten Abschnitt beeinträchtigt, die genannte Grösse einen Betrag aufweist, der im wesentlichen und bis auf eine Multiplikationskonstante gleich dem Integral der Augenblicksdifferenz zwischen der genannten hinlaufenden Leistungsschwingung (A1, A2), verzögert um ein Zeitintervall, das höchstens gleich dem Zweifachen der Ausbreitungszeit einer vorübergehenden Leistungsschwingung über den geschützten Abschnitt ist, und der genannten rücklaufenden vorübergehenden Leistungsschwingung (R1, R2) ist.

2. Verfahren nach Anspruch 1, dadurch gekennzeichnet, dass das genannte Verzögerungsintervall ungefähr gleich der Ausbreitungszeit einer vorübergehenden Leistungsschwingung über den geschützten Abschnitt ist.

3. Verfahren nach Anspruch 1, dadurch gekenn-

5

zeichnet, dass die genannte vorübergehende hinlaufende und verzögerte Leistungsschwingung in jedem Zeitpunkt dadurch erhalten wird, dass aus der vorübergehenden Leistungsschwingung, die zu diesem Zeitpunkt durch den Messpunkt (M) geht, und den Kenndaten (R, L) des genannten Netzelementes der hinlaufende Bruchteil der vorübergehenden Leistungsschwingung simuliert wird, der nach Durchquerung des Messpunktes zu einem späteren Zeitpunkt durchlaufen wird oder zumindest bei einem Netzelement durchlaufen würde, das frei von Fehlern ist und auf dem sich dieselben vorübergehenden Leistungsschwingungen ausbreiten, und zwar in einem Punkte (X) des geschützten Abschnittes, der von dem Messpunkt entfernt ist.

4. Verfahren nach Anspruch 3, dadurch gekennzeichnet, dass der genannte, von dem Messpunkt entfernte Punkt (X) im wesentlichen in der Mitte des geschützten Abschnittes (3, 4) liegt.

5. Verfahren nach Anspruch 3 oder 4, dadurch gekennzeichnet, dass das genannte Netzelement eine kurze Leitung (1) ist, die eine vernachlässigbare Gesamtkapazität aufweist.

**Claims**

1. A method for determining, at a measuring point situated at one end of a protected section (3, 4) of a part, such as an electricity transmission line (1), of an electrical energy transfer network, the direction, relative to that point, which indicates the origin of a disturbance affecting that part, comprising the steps of: forming, from signals indicative of the voltage and current at the measuring point, a quantity having the algebraic sign of the integral of the difference between a forward transient power wave (A1, A2) passing the measuring point and proceeding from outside the protected section towards that section and a backward transient power wave (R1, R2) passing the measuring point and proceeding from the protected section towards the outside, the said integral representing the total transient energy passing the measuring point; and deriving the said direction from the algebraic sign of the said quantity; characterized in that, to increase the reliability of the determination of the said direction in the case of a disturbance affecting the protected section, the said quantity has a modulus substantially equal, apart from a constant of multiplication, to the integral of the instantaneous difference between the said forward transient power wave, delayed by a period of time at most equal to twice the propagation time of a transient power wave over the protected section, and the said backward transient power wave.

2. A method according to claim 1, characterized in that the said delay period is close to the propagation time of a transient power wave over the protected section.

3. A method according to claim 1, characterized in that the said delayed forward transient power wave is obtained at any instant by deriving, from the transient power wave passing the measuring point at that instant and the characteristics of the said part of the network, the forward fraction of the transient power wave which, having passed the measuring point, at a later instant will pass a point on the protected section spaced from the measuring point, or at least would pass it in a fault-free part of the network on which the same transient power waves were travelling.

4. A method according to claim 3, characterized in that the said point spaced from the measuring point is substantially the mid-point of the protected section.

5. A method according to claim 3 or claim 4, characterized in that the said part of the network is a line having a negligible total capacitance.

FIG.1

FIG.2

FIG.3

FIG.4

FIG. 5

FIG. 6